# EUROPÄISCHE PATENTANMELDUNG

(11) **EP 0 643 242 A1**
(43) Veröffentlichungstag der Anmeldung: **15.03.1995**
(21) Anmeldenummer: 94111912.5
(22) Anmeldetag: 29.07.1994
(51) Int. Cl.: F16J 9/26, F02B 77/02, F02B 77/04

(54) **Bauteil im Bereich von Arbeitsräumen, wie Verbrennungsräumen, von Kraft- oder Arbeitsmaschinen mit einer Beschichtung**

(30) Priorität: 30.07.1993 DE 4325520
(71) Anmelder: NAGEL Maschinen- und Werkzeugfabrik GmbH, D-72622 Nürtingen (DE); Kuhn, Hans, D-50933 Köln (DE)
(72) Erfinder: Nagel, Wolf, D-72622 Nürtingen (DE); Kuhn, Hans, D-50933 Köln (DE)
(74) Vertreter: Patentanwälte Ruff, Beier, Schöndorf und Mütschele

(57) **Zusammenfassung**

Eine Kolbenringbeschichtung besteht aus einem reaktionsträgen, antiadhäsiven Metall, wie beispielsweise Niob oder Zircon. Sie wird im Target-Verfahren im Vakuum aufgebracht und hat eine geringe Dicke in der Größenordnung von acht µm. Zusammen mit einer eigenen Schlußbearbeitung durch Honen in Axialrichtung und im Zusammenwirken mit einer entsprechenden Zylinderlauffläche ergibt sich ein verbessertes Einlaufverhalten und geringere Schadstoffbildung sowie bessere Dichtigkeit und Ölabstreifung.

## Beschreibung

Vor Verbessung der Lauf- und Verschleißeigenschaften von Kolbenringen sind zahlreiche Beschichtungen vorgeschlagen worden. So wird nach der OS-38 12 656 eine Verbund-Nickelschicht aufplatiert, die OS-35 02 143 schläge bei einem Ring aus rostfreiem Stahl vor, die Außenschicht nitriert zu härten. Die DE-OS-3 041 225 beschreibt eine Flammspritzung mit einem Material, das aus Ferrochrom sowie Nickel-Chrom-Kobalt oder Molybdän besteht. Auch nach der DE-OS-3 017 907 wird durch Flammspritzung ein Metallcarbid und Molybdän aufgebracht.

Die DE-A-284 722 schlägt vor, durch Plasmastrahl ein oxidkeramisches Material, wie Titanoxid oder Aluminiumoxid aufzubringen. Auch nach dem DE-U-1 882 791 soll ein Aluminiumoxid zur Verbesserung des Verschleißverhaltens aufgebracht werden, das von einer weichen Einlaufschicht aus nicht genanntem Material überdeckt wird.

Das DE-U-1 953 020 schlägt eine Beschichtung aus einem porösen verschleißfesten Werkstoff, wie Molybdän oder Titan durch Flammspritzen vor. Nach der DE-C-154 626 sollen Poren des Kolbenringmaterials mit Weichmetall gefüllt werden. Bei der DE-C-837 041 wird auf ein Grundmaterial aus Stahl Bleibronze aufgebracht.

Die DE-A-1 215 440 schlägt eine Chrombeschichtung mit in Nuten eingesetztem Einlaufwerkstoff aus Kupfer, Zinn, Bronze oder Kunststoff vor. Auch die DE-A-38 13 617 verwendet auf Chromunterlage Kupfer, Zinn oder Zink.

Bei all diesen Maßnahmen ging es darum, ein verbessertes Einlaufverhalten zu erreichen, ohne die Verschleißfestigkeit herabzusetzen.

Auch die Erfindung hat sich zur Aufgabe gesetzt, Verschleißfestigkeit und Einlaufverhalten und Gleitreibung zu optimieren, diese Optimierung aber auch auf die Dichtfunktion, das mechanische Verhalten und den Schadstoffausstoß auszudehnen.

Diese Aufgabe wird gemäß der Erfindung dadurch gelöst, daß die Beschichtung aus einem reaktionsträgen, antiadhesiven Metall besteht.

Dieses Metall kann ein Metall aus der vierten oder fünften Nebengruppe des Periodensystems der Elemente sein, insbesondere Niob oder Zirconium. Tantal, Hafnium und Wolfram eignen sich ebenfalls. Iridium, Palladium und Platin wären geeignet, sind jedoch sehr teuer.

Mit gewissen Einschränkungen eignet sich auch Titan, das relativ weich ist.

Wenn das Bauteil ein Kolbenring ist, kann als Grundmaterial das übliche Gußmaterial auf Eisenbasis verwendet werden, das normalerweise sehr hart ist. Das Material sollte auch im Zusammenhang mit dem damit zusammenwirkenden Material der Zylinderlaufbahn ausgesucht werden. Die Beschichtung kann auf eine axial gehont Oberfläche aufgebracht, ggf. aber auch selbst axial gehont werden.

Besonders eignet sich die Beschichtung im Zusammenwirken mit einer Zylinderlaufbahn, die durch axiale Honbearbeitung nicht die üblichen Kreuz-Bearbeitungsspuren aufweist, sondern axial verlaufende Bearbeitungsspuren. Es ist festgestellt worden, daß diese Maßnahme, insbesondere wenn sie noch dadurch unterstützt wird, daß auch die Kolbenringe und/oder ihre Beschichtung durch axiale Schlußbearbeitung einen derartigen Spurenverlauf aufweisen, ein wesentlich verbessertes Einlaufverhalten haben. Während bei den normalen Hon-Kreuzspuren das Einlaufen ein "Glattschleifen" der gesamten Zylinderlauffläche bedingt, ist bei der vorherigen Längsbearbeitung im Zusammenhang mit der Beschichtung lediglich eine gegenseitige Anpassung notwendig, die auch durch gegenseitiges "Eingraben" unterstützt wird, wobei die Zylinderlauffläche nur wenig beeinflußt wird.

Aus diesem Grund kommt es auf die Härte, Verschleißfestigkeit und Gleitreibung der einzelnen Werkstoffe bzw. die Härteverhältnisse in der Werkstoffpaarung nicht so stark an, weil durch die gegenseitige Anpassung wenig Reibung auftritt und viel schneller in hydrodynamisches Tragen unter Einwirkung einer sehr dünnen Ölschicht auftritt.

Vor allem wird aber durch die antihaftenden Eigenschaften des Werkstoffs auch eine verringerte Bildung von Ölkohle erreicht. Die Raktionsträgheit der verwendeten Beschichtungswerkstoffe verhindert die Bildung von Carbonylen, die durch

Reaktion der Metalle durch Kohlenoxid entstehen, das Metall abtragen und außerdem Schadstoffe sind.

Die Aufbringung der Beschichtung sollte im Target-Verfahren (PVD-Arc-Verfahren) erfolgen, d. h. einer Beschichtung, bei der im Vakuum durch eine Plasmabeschichtung mit Lichtbogen das Metall aufgetragen wird.

Obwohl einige der Eigenschaften hauptsächlich im Zusammenhang mit der der Zylinderlaufbahn zugekehrten Oberfläche des Kolbenringes wichtig sind, kann die Beschichtung auch an den anderen Seiten erfolgen, wobei die antihaftende und reaktionsträge Wirkung der Beschichtung auch dort Vorteile bringt, indem weniger Verbrennungsrückstände sich ansetzen und mit dem Metall reagieren können.

Die Beschichtung hat außerdem den Vorteil, daß sie kurzwellige Unebenheiten auf der Oberfläche ausgleicht bzw. ausfüllt. Sie hat gute Gleitreibungseigenschaften.

Durch die beschriebene gegenseitige Anpassung sind Dichtwirkung und Ölabstreifung durch den beschriebenen beschichteten Kolbenring besser, was dazu führen kann, daß evtl. einer der üblicherweise drei verwendeten Kolbenring unnötig wird. Dies verbessert weiter auch die mechanischen Laufeigenschaften, d. h. es verringert die Reibung und die Erwärmung im Kolbenring selbst. Die Ausdehnungskoeffizienten und Wärmeleitfähigkeiten der zusammenwirkenden Metalle sollten aufeinander abgestimmt sein.

Auch andere Bauteile, die den Verbrennungsgasen direkt ausgesetzt sind, können vorteilhaft mit der Beschichtung versehen sein, insbesondere Ventile und Ventilsitze. Auch dort verhindert die Beschichtung mit den reaktionsträgen und verschleißarmen Metallen das Entstehen von Kartonylen und erhöht die Standzeit. Es werden auch schädliche Ablagerungen von Spaltprodukten der Verbrennung verhindert und die Funktion der Ventile und Ventilsitze gefördert. Die Bauteile können gänzlich mit dem vorher sowie im folgenden noch detailliert beschriebenem Target-Verfahren beschichtet sein.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Ausführungsbeispiele der Erfindung sind in den Zeichnungen dargestellt und werden im folgenden näher erläutert. Es zeigen:
- Fig. 1a: Die Bearbeitungsspuren einer üblichen Honbearbeitung auf einer bearbeiteten Fläche,
- Fig. 1b: die Bearbeitungsspuren auf einer erfindungsgemäß bearbeiteten Zylinder-Innenfläche,
- Fig. 2: einen schematischen Querschnitt durch ein Honwerkzeug
- Fig. 3 und 4: schematische Seitenansichten von Ausführungsformen von Honwerkzeugen und
- Fig. 5: einen vergrößerten Teil-Querschnitt durch einen Kolbenring.

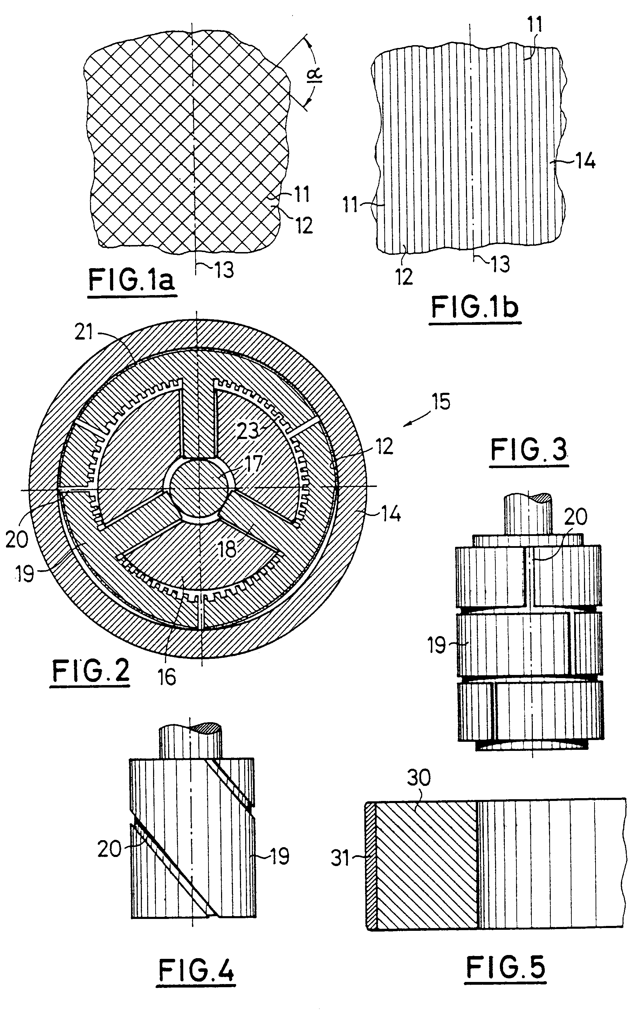

Übliche Honwerkzeuge bearbeiten eine Bohrung mit einem bohrungsfüllenden Werkzeug in einer überlagerten Dreh- und Hubbewegung, wobei die beiden Bewegungskomponenten etwa gleich groß sind. Dadurch entstehen auf der Werkstückoberfläche kreuzförmige Bearbeitungsspuren, die sich unter einem Winkel a in der Größenordnung von 45 bis 90°, vorzugsweise 60° kreuzen (Fig. 1). Üblicherweise wurde beim Vorhonen der Winkel größer gewählt, d. h. dort waren Umfangs- und Hubgeschwindigkeit etwa gleich, während zur Erzeugung der endgültigen Oberfläche die Hubgeschwindigkeit im Vergleich zur Umfangsgeschwindigkeit reduziert wurde. Damit sollte die Oberfläche verbessert und Makro-Ungenauigkeiten vermieden werden.

Die Erfindung geht nun den entgegengesetzten Weg und schlägt vor, die Honbearbeitung beim abschließenden Honvorgang statt mit größerer Umfangskomponente axial vorzunehmen, so daß schließlich Bearbeitungsspuren 11 auf der Werkstückoberfläche 12 entstehen, die möglichst genau parallel zur Achse 13 der Zylinderinnenbohrung verlaufen (Fig. 2). Bei dem Werkstück 13 handelt es sich um einen Zylinder 14 eines Verbrennungsmotors, der mit einem Kolben und darauf angeordneten Kolbenringen gleitend zusammenarbeitet.

Die Bearbeitungsspuren 11 auf der Oberfläche 12 haben zwar, da es sich beim Honen um eine Feinbearbeitung handelt, nur eine Tiefe in der Größenordnung von µm, bestimmen jedoch das Einlauf- und Dauerverhalten.

Im Gegensatz zu den üblichen Honverfahren kann bei der Erfindung mit überlagerter Umfangs- und Honbewegung vorgehont werden, während dann die Schlußbearbeitung mit rein axialer Führung des Honwerkzeuges erfolgt. Dies ist der Tendenz üblicher Honverfahren entgegengesetzt. Damit wird eine Vergleichmäßigung der Umfangsrichtung bereits beim Vorhonen erzeugt und die für die Funktion wichtige Oberflächenstruktur mit längsverlaufenden Erarbeitungsspuren wird im nachfolgenden Schluß-Bearbeitungsgang erzeugt.

Besonders bevorzugt ist es, wenn das Honen ganz ohne Umfangsbewegung erfolgt. Verbesserungen können allerdings auch schon erzielt werden, wenn die Umfangsbewegung sehr gering ist, beispielsweise nicht mehr als ein fünfzigstel oder, noch besser, hundertstel der Axialbewegung beträgt. Bevorzugte Bearbeitungsgeschwindigkeiten sind etwa 10 bis 50 m/min in Axialrichtung, vorzugsweise 15 bis 30 m/min, während Umfangsgeschwindigkeiten unter 1 (0,1) m/min liegen sollten. Es kann auch ein mehrstufiger oder auch stufenloser Übergang zwischen dem Vorhonen mit Umfangsbewegung und der Endbearbeitung weitgehend ohne Umfangsbewegung erfolgen, indem die Umfangsgeschwindigkeit stufenweise oder kontinuierlich immer weiter reduziert wird. Durch die Überlagerung der Bearbeitungsspuren (Kreuz- und Axial-) wird, insbesondere, wenn das Vorhonen mit Kreuzspuren mit einer weniger feinen Schleifmittelschicht erfolgt, eine "Plateauwirkung" erzielt, d. h. das feinere Werkzeug arbeitet die darunterliegenden Kreuzspuren an ihrer Oberfläche ab und schafft dort eine axiale Bearbeitungsspurenbahn, während die verbleibenden Vertiefungen vom Vorhonen noch Öltaschen bilden, falls diese für erforderlich gehalten werden.

Durch die hervorragenden Gleiteigenschaften im Zusammenwirken mit den darauf laufenden Kolbenringen ist es allerdings möglich, auf eine bewußte Ölhaltung an der Zylinderoberfläche zu verzichten, so daß das Ölbett besser abgestreift wird und daher im Verbrennungsraum weniger verbrannt wird.

Fig. 2 zeigt ein Honwerkzeug 15, das speziell zum Axialhonen vorgesehen und als Segmentwerkzeug ausgebildet ist. Es hat einen Werkzeugkörper 16, in dessen Innenbohrung ein Aufweitkonus 17 läuft, der über Betätigungskeile 18 Schneidbelagträger, im folgenden als Honsegmente 19 bezeichnet, zur bohrungsfüllenden Bearbeitung anstellen kann. Die beim Ausführungsbeispiel vorgesehenen drei Honsegmente schließen mit relativ geringen Zwischenräumen 20 aneinander an.

Die Honsegmente 19, die eine möglichst großflächige, in Umfangsrichtung möglichst ununterbrochene Schleifmittelschicht 21 aufweisen, sind derart federnd ausgebildet, daß sie in ihren von den Aufweitkeilen 18 entfernten Außenbereichen 22 federnd nachgeben können. Diese Federung oder Elastizität ist so bemessen, daß, auch unter Berücksichtigung der sich durch die Krümmung des Segments ergebenden Kräfteverhältnisse, bei der üblichen Bearbeitungskraft eine möglichst gleichmäßige Kraftverteilung über die gesamte Segmentfläche ergibt. Die Federung ist im vorliegenden Beispiel durch rückwärtige Einschnitte 23 des Honwerkzeuges gebildet, die im wesentlichen axial verlaufen und, abhängig von ihrem Abstand von der Unterstützung durch die Aufweitkeile 18, unterschiedlich tief sein können. Es sind auch andere Federungsmöglichkeiten denkbar, beispielsweise durch elastische Zwischenlagen.

Fig. 2 zeigt in der oberen Hälfte die an die Bohrungswandung angelegten, d. h. angestellten Segmente 19, während in der unteren Hälfte die Segmente 19 gerade erst beginnen, sich anzudrücken. Sie haben daher noch eine geringere Krümmung als die Bohrungswandung. Sie passen sie erst unter der Anstellkraft an.

Besonders bevorzugt sind Schleifbeläge aus Bornitrid (CBN) oder Diamantbeläge in metallischer Bindung. Es können aber auch Siliziumkarbid oder Korund enthaltende Keramik- oder Kunststoffbeläge verwendet werden. Es werden dadurch sich an die Bohrungsform selbst anpassende Schneidbeläge geschaffen, die vor allem auch Durchmessertoleranzen ausgleichen.

Es können in Umfangsrichtung schräge und/oder pfeilförmige Spanabfuhrnuten vorgesehen sein.

Bei diesem Werkzeug sollte, sofern mit genau axialer Bearbeitungsrichtung gearbeitet wird, ein stufenweiser Umfangsversatz vorgesehen werden, wozu vorzugsweise die Honbeläge durch Zurückziehen des Aufweitkonus 17 kurz entlastet werden, bevor das Honwerkzeug um einen Betrag, der kleiner ist als die Breite der Segmente weitergedreht wird. Dadurch wird erreicht, daß alle Umfangsbereiche möglichst gleichmäßig gehont werden.

Es ist aber möglich, entsprechend Fig. 3 mehrere Segmente in Axialrichtung hintereinander zu schalten und dort jeweils die Zwischenräume 20 zwischen den Segmenten versetzt anzuordnen. Bei entsprechender Wahl der unterschiedlichen Zwischenraum-Breiten kann auch ohne Weiterdrehung eine gleichmäßige Bearbeitung erfolgen.

Es ist ferner möglich, gemäß Fig. 4 die Segmente mit schräg angeordneten Zwischenräumen 20 oder mit pfeilförmigen Nuten aufzubauen, wodurch sich auch eine verbesserte Späneabfuhr im Bereich der Zwischenräume ergibt.

Die erfindungsgemäß bearbeiteten Zylinderlaufflächen sollten bevorzugt mit Kolbenringen 30 zusammenarbeiten, die auf einem üblichen Eisen-Gußmaterial mit einer Härte von z.B. 60 - 70 HRC eine Beschichtung 31 (Fig. 5) aufweisen.

Als Beschichtungsmaterialien sind insbesondere Niob, Wolfram und Circon bevorzugt, Titan und Tantal wären ebenfalls gut geeignet, während die Elemente Iridium, Palladium und Platin zwar vorteilhafte Eigenschaften zeigen, jedoch sehr teuer sind.

Bei der Materialwahl sollte vor allem auf antihaftende und reaktionsträge Eigenschaften geachtet werden, damit sich einerseits Öl- und Ölkohle nicht ansetzt und die Bildung von Metall-Carbonylen verhindert wird. Diese würden einerseits das Metall abtragen und wären andererseits Schadstoffe.

Obwohl die Härte der Kolbenring-Beschichtung üblicherweise größer ist als die der Zylinderlaufflächen (Niob bei 49 HRC, Circon bei 60 HRC und Wolfram bei 72 HRC), entsteht doch ein gewisser Einschleifvorgang, bei dem sich die beiden zusammenarbeitenden Oberflächen aneinander anpassen. Wenn vorzugsweise auch die Oberfläche der Kolbenringe eine Schlußbearbeitung in Axialrichtung, beispielsweise durch Axial-Außenhonen im Paket, erhält, dann ergibt sich nach kurzer Einlaufzeit eine ideale Anpassung, so daß schon bei geringer Ölfilmdicke ein hydraulisches Tragen und damit eine Verschleißfreiheit erreicht wird.

Auch bei härteren Kolbenlaufbahnen, beispielsweise durch Bohrnitritzusätze im Material oder ein Einbetten von Siliciumkörnern in eine Nickelbeschichtung, wirkt die Beschichtung vorteilhaft.

Die Beschichtung erfolgt im Vakuum durch eine Plasma-Beschichtung mit Lichtbogen, d. h. eine sogenannte Target-Beschichtung.

Ein solches PVD-Arc-Verfahren arbeitet wie folgt:

Die Werkstücke werden auf einem Halterungssystem in die Bearbeitungskammer gebracht. Hierauf wird in der Kammer ein Hochvakuum erzeugt. Dann wird die Beschichtung auf eine Temperatur von 200°C bis 400°C aufgeheizt und durch "Sputtern" eine intensive Reinigung der Werkstücke vorgenommen. Im Anschluß verdampft ein Lichtbogen die Kathode (Target). Durch diesen Prozeß findet eine Umwandlung des Kathodenmaterials vom festen in einen hochenergisch geladenen Ionendampf statt. Das ionisierte Material aus Circon, Niob oder anderen Metallen schlägt sich in Verbindung mit dem eingelassenen Reaktivgas (Stickstoff) auf den Werkstücken nieder und verbindet sich mit dem Trägerwerkstoff.

Der Vorteil dieses PVD-Verfahrens (physikalische Abscheidung aus der Dampfphase) gegenüber dem CVD-Verfahren (chemische Abscheidung aus der Dampfphase) besteht darin, daß beim PVD-Verfahren eine Abscheidung vom Hartstoff schon zwischen 200°C bis 400°C erfolgt, während das CVD-Verfahren für die chemische Reaktion Temperaturen von 800°C bis 1100°C erfordert und bezüglich Härte, Verzug etc. weniger vorteilhafte Ergebnisse liefert.

Auch das Flammspritzverfahren erscheint für bestimmte Anwendungen brauchbar, aber es ist wegen durchgängiger Porosität, mangelnder Haftung und rauher Oberfläche nachteiliger. Ferner ermöglicht es keine Aufbringung von Innenflächen und erfordert aufwendige Nacharbeit.

Die Schichtdicke beträgt nur wenige µm, z. B. zwischen 5 und 15 µm, vorzugsweise 8 µm. Die Beschichtung kann auf allen Kolbenringtypen vorgesehen sein. Üblicherweise sind bei einem KFZ-Motor axial drei Kolbenringe hintereinander angeordnet, und zwar, vom Verbrennungsraum aus betrachtet, zuerst ein balliger Ring, danach ein sogenannter Minutenring, der eine sich vom Verbrennungsraum aus erweiternde Schrägstellung in der Größenordnung von Winkelminuten hat und danach ein mit einer Mittelnut versehener Ölabstreifring. Wegen der hervorragenden Eigenschaften sowohl des Ringes als auch der entsprechend vorbereiteten Lauffläche kann ggf. auf einen dieser Ringe verzichtet werden. Die Beschichtung hat noch den Vorteil, daß sie eventuelle Unebenheiten der Kolbenringoberfläche ausgleicht.

## Patentansprüche

1. Bauteil im Bereich von Arbeitsräumen, wie Verbrennungsräumen, von Kraft- und Arbeitsmaschinen, insbesondere Verbrennungskraftmaschinen, mit einer Beschichtung (31) zumindest an seiner dem Arbeitsraum bzw. dem Arbeitsmedium zugekehrten Fläche, dadurch gekennzeichnet, daß die Beschichtung (31) aus einem reaktionsträgen, antiadhäsiven Metall besteht.

2. Bauteil nach Anspruch 1, dadurch gekennzeichnet, daß das Bauteil einen Kolbenring (30) ist und die Beschichtung zumindest auf seiner der Zylinderwandung zugekehrten Seite vorgesehen ist.

3. Bauteil nach Anspruch 1 oder 2, dadurch gekennzeichnet, daß die Beschichtung aus einem Metall der vierten oder fünften Nebengruppe des Periodensystems der Elemente oder Wolfram besteht, vorzugsweise aus Niob oder Zircon.

4. Bauteil nach einem der vorhergehenden Ansprüche, dadurch gekennzeichnet, daß die Beschichtung (31) im Target-Verfahren (PVD-Arc-Verfahren) aufgebracht ist.

5. Bauteil nach einem der Ansprüche 2 bis 4, dadurch gekennzeichnet, daß Bearbeitungsspuren auf der Arbeitsfläche in Richtung der Achse des Kolbenringes (30) verlaufen.

6. Bauteil nach einem der Ansprüche 2 bis 5, dadurch gekennzeichnet, daß die Arbeitsfläche des Kolbenringes (30) mit einer Zylinderwandung (12) zusammenwirkt, die in axialer Richtung verlaufende Bearbeitungsspuren (11) aufweist.

7. Bauteil nach einem der vorhergehenden Ansprüche, dadurch gekennzeichnet, daß es ein Ventilkörper und/oder ein Ventilsitz der Verbrennungskraftmaschine ist.
